(19) Europäisches Patentamt European Patent Office Office européen des brevets

(11) **EP 3 667 275 B1**

(12) **FASCICULE DE BREVET EUROPEEN**

(45) Date de publication et mention de la délivrance du brevet:
**14.04.2021 Bulletin 2021/15**

(21) Numéro de dépôt: **19215048.0**

(22) Date de dépôt: **10.12.2019**

(51) Int Cl.:
*G01K 7/01* *(2006.01)*    *G01K 7/32* *(2006.01)*

(54) **CAPTEUR DE TEMPÉRATURE**

TEMPERATURSENSOR

TEMPERATURE SENSOR

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **11.12.2018 FR 1872708**

(43) Date de publication de la demande:
**17.06.2020 Bulletin 2020/25**

(73) Titulaire: **Commissariat à l'Energie Atomique et aux Energies Alternatives
75015 Paris (FR)**

(72) Inventeurs:
• **BADETS, Franck
38054 GRENOBLE CEDEX 9 (FR)**
• **COZZI, Maxime
38054 GRENOBLE CEDEX 9 (FR)**

(74) Mandataire: **Cabinet Beaumont
4, Place Robert Schuman
B.P. 1529
38025 Grenoble Cedex 1 (FR)**

(56) Documents cités:
**WO-A1-2018/115864     US-A1- 2009 096 495
US-A1- 2017 038 264**

**Description**

Domaine technique

La présente invention concerne de façon générale les capteurs de température.

Technique antérieure

Pour certaines applications, il existe un besoin d'un capteur de température fournissant un signal sensiblement linéaire en fonction de la température sur une plage étendue de températures, par exemple de -40°C à 250°C. Il existe un besoin que le capteur de température soit peu encombrant et de faible consommation. Dans ce but, il serait souhaitable que le capteur de température puisse être réalisé au moins en partie de façon commune avec un autre circuit électronique.

Le document US 2017/038264 décrit des oscillateurs en anneau pour détection de température dans des environnements à bruit d'alimentation large bande.

Le document US 2009/096495 décrit un oscillateur en anneau pour capteur de température, un circuit capteur de température et un dispositif semiconducteur pourvu d'un tel capteur.

Le document WO 2018/115864 décrit des circuit d'échantillonnage de tension.

Résumé de l'invention

Ainsi, un objet d'un mode de réalisation est de pallier au moins en partie les inconvénients des capteurs de température décrits précédemment.

Un mode de réalisation prévoit un capteur de température fournissant un signal de mesure de la température, comprenant une source de courant commandable, un oscillateur et un circuit de commande de la source de courant commandable configuré pour asservir la résistance équivalente de l'oscillateur à une résistance de référence, l'oscillateur étant alimenté par la source de courant commandable en un premier noeud présentant une tension d'alimentation, l'oscillateur fournissant un premier signal oscillant, ayant une dynamique égale à la tension d'alimentation, le signal de mesure correspondant à la tension d'alimentation.

Selon un mode de réalisation, la source de courant commandable comprend un premier transistor MOS dont la source est destinée à être reliée à une source d'un potentiel de référence haut, dont le drain fournit la tension d'alimentation au premier noeud et dont la grille est commandée par le circuit de commande.

Selon un mode de réalisation, le capteur de température comprend un convertisseur analogique-numérique recevant la tension d'alimentation et fournissant un signal numérique converti au circuit de commande, le circuit de commande étant configuré pour sélectionner une résistance parmi des résistances à partir du signal numérique converti, lesdites résistances étant sensiblement égales à la résistance de référence dans des sous-plages différentes de températures d'une plage de températures.

Selon un mode de réalisation, le capteur de température comprend un circuit suiveur recevant la tension d'alimentation et fournissant en sortie une recopie de la tension d'alimentation et comprend le convertisseur analogique-numérique relié à la sortie du circuit suiveur.

Selon un mode de réalisation, le circuit de commande et la source de courant commandable comprennent un miroir de courant comprenant le premier transistor MOS et un deuxième transistor MOS, le circuit de commande comprenant, en outre, un amplificateur opérationnel dont la sortie est reliée aux grilles des premier et deuxième transistors MOS, dans lequel le premier noeud est relié à une première entrée de l'amplificateur opérationnel et le circuit de commande comprend un circuit de fourniture d'une tension de référence à une deuxième entrée de l'amplificateur opérationnel, le deuxième transistor MOS étant traversé par un courant, le circuit de fourniture étant configuré pour fournir la tension de référence égale au produit dudit courant et de la résistance de référence.

Selon un mode de réalisation, le circuit de fourniture de la tension de référence est adapté à relier la deuxième entrée à l'une desdites résistances à partir d'un signal de sélection.

Selon un mode de réalisation, le circuit de commande comprend un circuit numérique recevant le signal numérique converti et déterminant le signal de sélection à partir du signal numérique converti de façon à sélectionner la résistance, parmi lesdites résistances, celle sensiblement égale à la résistance de référence.

Selon un mode de réalisation, le circuit de fourniture de la tension de référence comprend des premiers résistors, les premiers résistors ayant des résistances sensiblement égales à la résistance de référence dans des sous-plages différentes de températures d'une plage de températures, et un démultiplexeur adapté à relier l'un des premiers résistors à la deuxième entrée à partir du signal de sélection.

Selon un mode de réalisation, le circuit de fourniture de la tension de référence comprend un deuxième résistor à résistance à coefficient de température positif relié à un troisième résistor à résistance à coefficient de température négatif et un circuit adapté à modifier le rapport entre le courant circulant dans le deuxième résistor et le courant circulant dans le troisième résistor.

Selon un mode de réalisation, l'oscillateur comprend des troisièmes transistors MOS.

Selon un mode de réalisation, le premier signal oscillant oscille à une première fréquence d'oscillation, le capteur de température comprenant un circuit diviseur de fréquence recevant le premier signal oscillant ou un deuxième signal oscillant à la première fréquence d'oscillation et fournissant un troisième signal oscillant à une deuxième fréquence d'oscillation qui est un sous-multiple de la première fréquence d'oscillation.

Selon un mode de réalisation, le convertisseur analogique-numérique est cadencé par le troisième signal oscillant.

Selon un mode de réalisation, l'oscillateur est un oscillateur en anneau.

Selon un mode de réalisation, la tension à chaque noeud interne de l'oscillateur a une dynamique égale à la tension d'alimentation.

Selon un mode de réalisation, les troisièmes transistors MOS sont configurés pour être traversés par un courant variant de façon linéaire, à 10 % prés, en fonction de la température sur une plage de températures, le capteur étant configuré pour fournir le signal de mesure variant de façon linéaire, à 10 % près, en fonction de la température au moins sur la plage de températures.

Selon un mode de réalisation, la plage de températures varie de -40°C à 250°C.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 représente, de façon partielle et schématique, un mode de réalisation d'un capteur de température ;

la figure 2 représente un mode de réalisation plus détaillé du capteur de température de la figure 1 ;

la figure 3 représente un mode de réalisation d'un oscillateur ;

la figure 4 représente des courbes de variation de résistances en fonction de la température ;

la figure 5 représente un mode de réalisation plus détaillé du dispositif représenté en figure 3 ;

la figure 6 représente une courbe d'évolution de la tension d'alimentation de l'oscillateur du dispositif représenté en figure 5 en fonction de la température ;

la figure 7 représente une variante de l'oscillateur du dispositif représenté en figure 3 ; et

la figure 8 représente une variante d'une autre partie du dispositif représenté en figure 3.

Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques. Par souci de clarté, seuls les éléments utiles à la compréhension des modes de réalisation décrits ont été représentés et sont détaillés. Sauf précision contraire, les expressions "environ", "approximativement", "sensiblement", et "de l'ordre de" signifient à 10 % près, de préférence à 5 % près. Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments. De plus, dans la suite de la description, les tensions sont référencées par rapport à un potentiel de référence bas, par exemple le potentiel de la masse, pris égal à 0 V. En outre, dans la suite de la description, on utilise la même référence pour désigner un résistor et la résistance de ce résistor. De plus, on appelle "signal binaire" un signal qui alterne entre un premier état constant, par exemple un état bas, noté "0", et un deuxième état constant, par exemple un état haut, noté "1". Les états haut et bas de signaux binaires différents d'un même circuit électronique peuvent être différents. En pratique, les signaux binaires peuvent correspondre à des tensions ou à des courants qui peuvent ne pas être parfaitement constants à l'état haut ou bas.

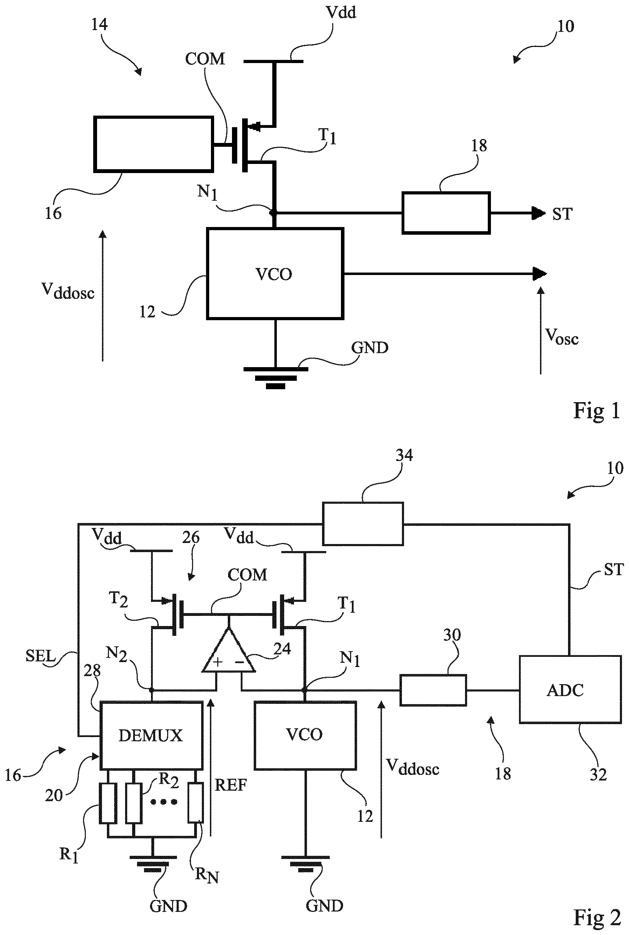

La figure 1 représente un mode de réalisation d'un capteur de température 10. Le capteur de température 10 comprend un oscillateur commandé en tension 12 (VCO). L'oscillateur 12 est relié, de préférence connecté, à une source GND d'un potentiel de référence bas, par exemple la masse. L'oscillateur 12 est en outre relié, de préférence connecté, à un noeud $N_1$ recevant une tension $V_{ddosc}$ d'alimentation de l'oscillateur 12. L'oscillateur 12 fournit un signal oscillant $V_{osc}$ à une fréquence d'oscillation f, par exemple une tension binaire alternant entre deux niveaux à la fréquence f. Le capteur 10 comprend, en outre, un circuit 14 de fourniture de la tension d'alimentation $V_{ddosc}$ comprenant une source de courant commandable alimentant l'oscillateur. La source de courant commandable comprend par exemple un transistor à effet de champ à grille isolée $T_1$, également appelé transistor MOS, par exemple à canal P, dont le drain est relié au noeud $N_1$ et dont la source est reliée à une source $V_{dd}$ d'un potentiel de référence haut. Le circuit 14 comprend en outre un circuit 16 de commande de la source de courant commandable, fournissant par exemple un signal de commande COM à la grille du transistor $T_1$. Le capteur de température 10 comprend, en outre, un circuit d'adaptation 18 recevant la tension d'alimentation $V_{ddosc}$ au noeud $N_1$ et fournissant un signal ST.

L'oscillateur 12 est configuré pour fournir le signal oscillant $V_{osc}$ avec une dynamique égale à la tension d'alimentation $V_{ddosc}$. Selon un mode de réalisation, le circuit 16 de commande de la source de courant commandable est configuré pour asservir la résistance équivalente de l'oscillateur 12 à une résistance de référence. Il en résulte une commande de l'oscillateur 12 pour que la fréquence d'oscillation f reste sensiblement constante. Avec une telle architecture, les inventeurs ont mis en évidence que les variations de la tension d'alimentation $V_{ddosc}$ sont représentatives des variations de la température.

L'oscillateur 12 est un oscillateur comprenant des transistors MOS, notamment des transistors MOS à canal P et/ou des transistors MOS canal N. L'oscillateur 12 est par exemple un oscillateur en anneaux. L'oscillateur 12 peut en outre comprendre d'autres composants électroniques, par exemple des condensateurs. Les composants électroniques de l'oscillateur 12 sont connectés les uns aux autres de sorte que, pour chaque noeud interne de l'oscillateur 12, c'est-à-dire chaque noeud entre deux composants électroniques de l'oscillateur 12, la tension au noeud varie en fonctionnement sur une plage de tension sensiblement égale à la tension d'alimentation $V_{ddosc}$. Pour un tel oscillateur 12, les inventeurs ont mis en évidence que la tension d'alimentation $V_{ddosc}$ varie de façon sensiblement linéaire avec la température sur une grande plage de températures, notamment au moins sur la plage variant de -40°C à 250°C.

Le signal ST, fourni par le circuit d'adaptation 18 et obtenu à partir de la tension d'alimentation $V_{ddosc}$, est un signal analogique ou numérique qui varie de façon sensiblement linéaire en fonction de la température. Selon un mode de réalisation, le circuit d'adaptation 18 comprend un convertisseur analogique-numérique. Selon un mode de réalisation, le circuit d'adaptation 18 comprend un circuit suiveur. Le circuit d'adaptation 18 peut ne pas être présent, le signal ST étant alors égal à la tension d'alimentation $V_{ddosc}$. Le signal ST peut être utilisé par un autre circuit électronique et/ou peut être utilisé par le capteur de température 10 lui-même. Le capteur de température 10 fournit donc à la fois le signal ST qui varie de façon sensiblement linéaire avec la température et le signal $V_{osc}$ qui oscille à la fréquence d'oscillation f.

La figure 2 représente un mode de réalisation plus détaillé du dispositif 10 représenté en figure 1 dans lequel le circuit de commande 16 comprend un circuit 20 de fourniture d'un signal de référence REF à un noeud $N_2$. Le circuit 20 comprend en outre un amplificateur opérationnel 24 recevant à l'entrée non inverseuse (+) le signal $V_{ddosc}$ et à l'entrée inverseuse (-) le signal REF et fournissant le signal de commande COM à la grille du transistor $T_1$ pour que les signaux $V_{ddosc}$ et REF deviennent égaux. Le dispositif 10 comprend en outre un miroir de courant à entrée active 26 comprenant l'amplificateur opérationnel 24, le transistor $T_1$ et un transistor MOS $T_2$, notamment à canal P, dont la source est reliée à la source Vdd du potentiel de référence haut, dont le drain est relié au noeud $N_2$ et dont la grille est reliée à la grille du transistor T1.

Le circuit 20 de fourniture du signal de référence REF comprend des résistors compensés en température $R_1$ à $R_N$ où N est un nombre entier, par exemple compris entre 1 et 6. Le circuit 20 comprend, en outre, un démultiplexeur 28 (DEMUX), chaque résistor $R_1$ à $R_N$ comprenant une première borne reliée, de préférence connectée, à la source GND du potentiel de référence bas et une deuxième borne reliée, de préférence connectée, à une entrée du démultiplexeur 28. Le démultiplexeur 28 est adapté à connecter l'un des résistors $R_1$ à $R_N$ au noeud $N_2$ en fonction d'un signal de sélection SEL.

Le circuit d'adaptation 18 comprend, dans le présent mode de réalisation, un circuit suiveur 30 relié à un convertisseur analogique-numérique 32 (ADC), l'entrée du circuit suiveur 30 étant reliée, de préférence connectée, au noeud $N_1$, la sortie du circuit suiveur 30 étant reliée, de préférence connectée, à l'entrée du convertisseur analogique-numérique 32, et le convertisseur analogique-numérique 32 fournissant le signal ST.

Le circuit de commande 16 comprend en outre un circuit numérique de sélection 34 de l'une des résistances $R_1$ à $R_N$, recevant le signal ST et fournissant un signal SEL de commande au démultiplexeur 28. Le circuit numérique de sélection 34 peut être alimenté par une source de fourniture d'un potentiel de référence haut, non représentée, différente de la source $V_{dd}$.

Chaque résistor $R_1$ à $R_N$ est un résistor dont la résistance varie en fonction de la température, par exemple en présentant successivement une phase de croissance en fonction de la température, le passage par un maximum et une phase de décroissance en fonction de la température. Selon un mode de réalisation, les résistances maximales des résistors $R_1$ à $R_N$ sont obtenues pour des températures croissantes, c'est-à-dire que pour tout couple i et j variant de 1 à N avec i strictement inférieur à j, la température à laquelle la résistance maximale du résistor $R_i$ est obtenue est

inférieure strictement à la température à laquelle la résistance maximale du résistor $R_j$ est obtenue. Selon un mode de réalisation, chaque résistor $R_1$ à $R_N$ comprend un résistor à coefficient de température négatif en série avec un résistor à coefficient de température positif.

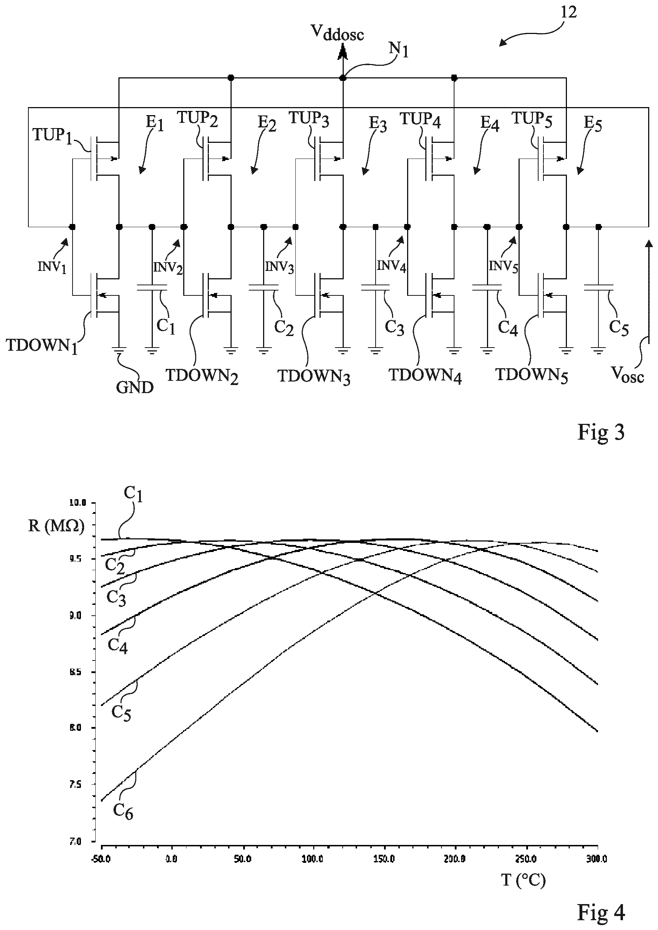

La figure 3 représente un mode de réalisation de l'oscillateur 12 dans lequel l'oscillateur 12 correspond à un oscillateur en anneau comprenant une succession d'étages $E_1$ à $E_M$, où M est un nombre entier impair au moins égal à 3, M étant égal à 5 dans le mode de réalisation représenté en figure 3. Chaque étage $E_j$, j variant de 1 à M, comprend un inverseur $INV_j$ et un condensateur $C_j$. L'entrée de l'inverseur $INV_j$ de l'étage $E_j$ est reliée, de préférence connectée, à la sortie de l'inverseur $INV_k$ de l'étage $E_k$, où k est supérieur ou égal à 1 et inférieur strictement à j et j est inférieur ou égal à N. L'entrée de l'inverseur $INV_1$ de l'étage $E_1$ est reliée, de préférence connectée, à la sortie de l'inverseur $INV_M$ de l'étage $E_M$. Le condensateur $C_j$ de l'étage $E_j$ comprend une première électrode reliée, de préférence connectée, à la sortie de l'inverseur $INV_j$ et une deuxième électrode reliée, de préférence connectée, à la source GND du potentiel de référence bas. Selon un mode de réalisation, l'inverseur $INV_j$ comprend un transistor MOS $TUP_j$, par exemple à canal P, dont la source est reliée, de préférence connectée, au noeud $N_1$, dont le drain est relié, de préférence connecté, à la sortie de l'inverseur $INV_j$ et dont la grille est reliée, de préférence connectée, à l'entrée de l'inverseur $INV_j$. Selon un mode de réalisation, l'inverseur $INV_j$ comprend un transistor MOS $TDOWN_j$, par exemple à canal N, dont la source est reliée, de préférence connectée, à la source GND du potentiel de référence bas, dont le drain est relié, de préférence connecté, à la sortie de l'inverseur $INV_j$ et dont la grille est reliée, de préférence connectée, à l'entrée de l'inverseur $INV_j$. Les condensateurs $C_j$ peuvent correspondre à des capacités internes des transistors MOS ou à des composants électroniques distincts. Les capacités des condensateurs $C_j$ peuvent être identiques.

La figure 4 représente des courbes d'évolution $C_1$ à $C_6$ de la résistance R de résistors $R_1$ à $R_6$ du circuit 20 en fonction de la température T. Chaque courbe $C_1$ à $C_6$ a la forme d'une cloche, les maxima des résistances $R_1$ à $R_6$ étant sensiblement égaux. Les courbes sont décalées en température les unes par rapport aux autres de sorte que les maxima des courbes $C_1$ à $C_6$ sont sensiblement régulièrement répartis sur la plage de température de -50°C à 250°C.

Le fonctionnement du dispositif 10 représenté en figure 3 est le suivant. Le signal ST, fourni par le convertisseur 32, correspond à la conversion analogique/numérique de la tension $V_{ddosc}$. La tension $V_{ddosc}$ variant sensiblement de façon linéaire avec la température, le signal numérique ST varie également sensiblement de façon linéaire avec la température. Le circuit de sélection 34 fournit le signal SEL pour la sélection de l'une des résistances $R_1$ à $R_N$ en fonction de la température indiquée par le signal ST. Selon un mode de réalisation, le circuit de sélection 34 comprend une mémoire dans laquelle sont stockées des seuils délimitant N plages $RT_1$ à $RT_N$ de température, successives et jointives, chaque plage de température $RT_i$ pour i variant de 1 à N, étant la plage dans laquelle la résistance $R_i$ passe par son maximum. De préférence, chaque plage de températures $RT_i$ est sensiblement centrée sur la température correspondant au maximum de la résistance $R_i$ associée. Le circuit de sélection 34 est alors adapté à comparer le signal ST aux seuils et à fournir un signal de sélection SEL de la résistance $R_i$ associée à la plage de températures $RT_i$ à laquelle appartient le signal SEL. Le démultiplexeur 28 relie alors la résistance $R_i$ sélectionnée au noeud $N_2$. Selon un mode de réalisation, le nombre N de résistors $R_i$ et l'étendue de chaque plage de températures $RT_i$ sont choisis de façon que la résistance $R_i$ associée à la plage de températures $RT_i$ varie par rapport au maximum de résistance de moins de 2 %, de préférence de moins de 0,5 %, sur la plage de températures $RT_i$. De ce fait, la résistance reliée au noeud $N_2$ est sensiblement constance à 2 % près, de préférence à 0,5 % près, sur une large étendue de températures, notamment de -40°C à 250°C.

La résistance équivalente $R_{dcosc}$ de l'oscillateur 12 est donnée par la relation 1) suivante :

[Math 1]

$$R_{dcosc} = V_{ddosc} I_{ddosc}$$

La tension à chaque noeud interne de l'oscillateur 12 variant en fonctionnement sur une plage de tension sensiblement égale à la tension d'alimentation $V_{ddosc}$, la puissance consommée par l'oscillateur 12 suit la relation 2) suivante, en appelant $C_{osc}$ la capacité équivalente de l'oscillateur 12 :

[Math 2]

$$P = C_{osc} f V_{ddosc}^2$$

A titre d'exemple, pour l'oscillateur 12 représenté en figure 3, la capacité $C_{osc}$ équivalente de l'oscillateur 12 est égale à $M*C_1$. La fréquence f du signal oscillant fourni par l'oscillateur 12 peut alors être exprimée en fonction de la résistance DC $R_{dcosc}$ de l'oscillateur 12 selon la relation 3) suivante :

[Math 3]

$$f = \frac{1}{R_{dcosc}C_{osc}}$$

L'amplificateur opérationnel 24 tend à maintenir égales la tension REF au noeud $N_2$ et la tension $V_{ddosc}$ au noeud $N_1$ et donc à maintenir égaux le courant $I_{ddosc}$ et le courant au noeud $N_2$. Tout se passe comme si le miroir de courant à entrée active 26 asservit la résistance $R_{dcosc}$ à être égale à la résistance $R_i$ reliée au noeud $N_2$, sélectionnée parmi les résistances $R_i$ à $R_N$. De ce fait, comme la résistance reliée au noeud $N_2$ est sensiblement constante quelle que soit la température sur une plage de températures étendue, notamment de -40°C à 250°C, la résistance $R_{ddosc}$ et donc la fréquence f de l'oscillateur 12 restent sensiblement constantes quelle que soit la température sur la plage de températures étendue, notamment de -40°C à 250°C. Ceci permet l'utilisation du signal $V_{osc}$ à fréquence stable dans des applications dans lesquelles la température peut varier de façon importante, notamment dans les domaines du forage, du suivi de processus industriels ou du suivi de paramètres de fonctionnement de moteurs dans des applications aéronautiques ou automobiles.

Un autre avantage est que le nombre de points de calibration nécessaires pour l'étalonnage de l'oscillateur 12 est réduit. En effet, un étalonnage à deux points suffit à étalonner l'oscillateur 12. La durée des tests de l'oscillateur 12 est donc réduite. Le coût de production de l'oscillateur 12 est donc réduit.

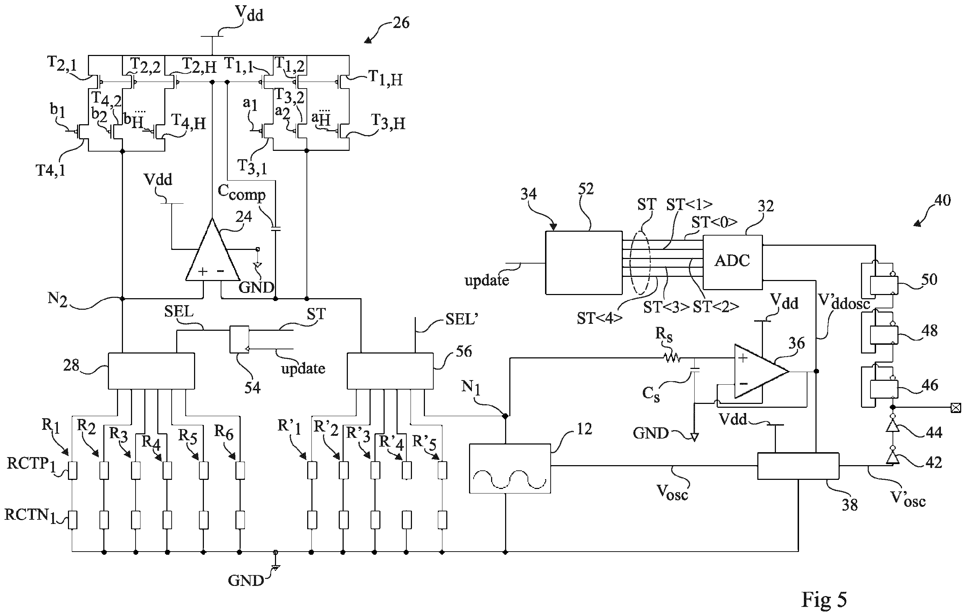

La figure 5 représente un mode de réalisation plus détaillé du dispositif 10 de la figure 3. En figure 5, chaque résistor $R_i$, i variant de 1 à N, comprend un résistor $RCTP_i$ à coefficient de température positif en série avec un résistor $RCTN_i$ à coefficient de température négatif.

Dans le présent mode de réalisation, le circuit miroir de courant 26 permet, en outre, d'étalonner la fréquence d'oscillation de l'oscillateur 12. Le circuit de miroir de courant 26 comprend un nombre H branches $A_i$, i variant de 1 à H, montées en parallèles entre l'entrée inverseuse (-) de l'amplificateur opérationnel 24 et la source $V_{dd}$ du potentiel de référence haut et H branches $A'_i$, i variant de 1 à H, montées en parallèles entre le noeud $N_2$ et la source $V_{dd}$ du potentiel de référence haut. Le nombre H peut varier de 1 à $2^N$ avec N pouvant varier de 1 à 10 par exemple. Chaque branche $A_i$ peut comprendre une source de courant réalisée par exemple par un transistor MOS $T_{1,i}$, par exemple à canal P, toujours passant dont la valeur de la tension sur la grille fixe la valeur du courant le traversant en série avec un transistor MOS $T_{3,i}$, par exemple à canal P. Chaque branche $A'_i$ peut comprendre une source de courant réalisée par exemple par un transistor MOS $T_{2,i}$, par exemple à canal P, toujours passant dont la valeur de la tension sur la grille fixe la valeur du courant le traversant en série avec un transistor MOS $T_{4,i}$, par exemple à canal P. La sortie de l'amplificateur opérationnel 24 est reliée, de préférence connectée, aux grilles des transistors $T_{1,1}$ à $T_{1,H}$ et $T_{2,1}$ à $T_{2,H}$. Les grilles des transistors $T_{3,1}$ à $T_{3,H}$ sont commandées respectivement par des commandes binaires $a_1$ à $a_0$ et les grilles des transistors $T_{4,1}$ à $T_{4,H}$ sont commandées respectivement par des commandes binaires $b_1$ à $b_0$. Les commandes binaires $a_1$ à $a_0$ et $b_1$ à $b_0$ permettent de sélectionner certaines des sources de courant parmi les transistors $T_{1,1}$ à $T_{1,H}$ et certaines des sources de courant parmi les transistors $T_{2,1}$ à $T_{2,H}$, ce qui permet de régler le rapport de courant traversant le résistor $R_i$ sélectionné et l'oscillateur 12. Cela permet d'étalonner la fréquence de l'oscillateur. Le circuit de commande 16 comprend, en outre, un condensateur $C_{comp}$ dont une électrode est reliée, de préférence connectée, aux grilles des transistors $T_{1,i}$ et $T_{2,i}$ et dont l'autre électrode est reliée, de préférence connectée, à l'entrée inverseuse (-) de l'amplificateur opérationnel 24.

En outre, on a représenté en figure 5 un mode de réalisation du circuit suiveur 30 dans lequel le circuit suiveur 30 comprend un amplificateur opérationnel 36 relié, pour son alimentation, à la source $V_{dd}$ du potentiel de référence haut, ou à une autre source d'un potentiel de référence haut, et à la source GND du potentiel de référence bas, recevant la tension $V_{ddosc}$ et fournissant la tension $V'_{ddosc}$ qui est une recopie de la tension $V_{ddosc}$. La sortie de l'amplificateur opérationnel 36 est reliée, de préférence connectée, à l'entrée inverseuse (V-) de l'amplificateur opérationnel 36. Le circuit suiveur 30 comprend, en outre, un résistor $R_s$ dont une borne est reliée, de préférence connectée, au noeud $N_1$ et dont l'autre borne est reliée, de préférence connectée, à l'entrée non inverseuse (+) de l'amplificateur opérationnel 36 et un condensateur $C_s$ dont une électrode est reliée, de préférence connectée, à la source GND du potentiel de référence bas et dont l'autre électrode est reliée, de préférence connectée, à l'entrée non inverseuse (+) de l'amplificateur opérationnel 36.

Selon un mode de réalisation, le circuit d'adaptation 18 comprend, en outre, un circuit de conversion de niveau 38 relié, pour son alimentation, à la source Vdd du potentiel de référence haut, ou à une autre source d'un potentiel de référence haut, et à la source GND du potentiel de référence bas, comprenant une entrée recevant le signal oscillant $V_{osc}$ fourni par l'oscillateur 12 et une sortie fournissant un signal oscillant $V'_{osc}$. Le circuit de conversion de niveau 38 comprend, en outre, une entrée reliée, de préférence connectée, à la sortie du circuit suiveur 30 et recevant le signal $V'_{ddosc}$. Le circuit de conversion de niveau 38 fournit le signal $V'_{osc}$ à la même fréquence f que le signal oscillant $V_{osc}$ mais avec une dynamique différente, qui dépend notamment du signal $V'_{ddosc}$. En particulier, lorsque le signal $V_{osc}$ est un signal binaire, le signal $V'_{osc}$ est un signal binaire suit le signal $V_{osc}$ avec des niveaux "0" et "1" différents.

Le circuit d'adaptation 18 comprend, en outre, un circuit diviseur de fréquence 40 adapté au cas où le signal $V'_{osc}$ est binaire. Le circuit 18 comprend deux inverseurs 42, 44 et trois bascules D 46, 48, 50. L'entrée du premier inverseur 42 reçoit le signal $V'_{osc}$. La sortie du premier inverseur 42 est reliée, de préférence connectée, à l'entrée du deuxième inverseur 44. La sortie du deuxième inverseur 44 est reliée, de préférence connectée, à l'entrée d'horloge de la première bascule D 46. La sortie non inversée de la première bascule D 46 est reliée, de préférence connectée, à l'entrée d'horloge de la deuxième bascule D 48. La sortie inversée de la première bascule D 46 est reliée, de préférence connectée, à l'entrée de données de la première bascule D 46. La sortie non inversée de la deuxième bascule D 48 est reliée, de préférence connectée, à l'entrée d'horloge de la troisième bascule D 50. La sortie inversée de la deuxième bascule D 48 est reliée, de préférence connectée, à l'entrée de données de la deuxième bascule D 48. La sortie inversée de la troisième bascule D 50 est reliée, de préférence connectée, à l'entrée de données de la troisième bascule D 50. La sortie non inversée de la troisième bascule D 50 fournit un signal Clk. Le signal Clk est un signal binaire qui oscille à une fréquence égale à f divisée par $2^Q$ où Q est le nombre de bascules D (Q étant égal à trois en figure 3).

Le convertisseur analogique-numérique 32 reçoit sur une entrée la tension $V'_{ddosc}$ et est cadencé par le signal Clk. Dans le présent mode de réalisation, le convertisseur analogique-numérique 32 fournit le signal numérique ST, correspondant à la conversion analogique/numérique de la tension $V'_{ddosc}$, codé par exemple sur 5 bits ST<0>, ST<1>, ST<2>, ST<3> et ST<4>.

Selon un mode de réalisation, le circuit de sélection 34 comprend un circuit 52 recevant le signal numérique ST et fournissant un signal update codé sur un bit. Le circuit 52 est adapté à fournir une impulsion du signal update lorsque la plage de températures désignée par le signal numérique ST change et éventuellement lorsque une ou des conditions supplémentaires sont remplies. Dans ce but, le circuit 52 peut comparer le signal numérique ST à des seuils. Selon un mode de réalisation, pour chaque borne d'une plage de températures, deux seuils de comparaison peuvent être utilisés, un premier seuil de comparaison lorsque le signal numérique ST est croissant et un deuxième seuil de comparaison lorsque le signal numérique ST est décroissant. Ceci permet d'obtenir un effet d'hystérésis pour éviter l'émission indésirable d'impulsions successives du signal update pour de faibles oscillations du signal ST autour d'un seuil. A titre de variante, le circuit 52 ne fournit une impulsion du signal update que lorsque le signal numérique désigne continument une nouvelle plage de températures pendant une durée donnée.

Le circuit de sélection 34 comprend, en outre, un circuit de commande 54 recevant le signal numérique ST et le signal update et fournissant le signal de sélection SEL. Selon un mode de réalisation, le circuit de commande 52 est adapté à déterminer une nouvelle valeur du signal de sélection SEL à partir de la dernière valeur du signal ST reçue à réception d'une impulsion du signal update.

Selon le mode de réalisation représenté en figure 5, le dispositif 10 comprend, en outre, des résistors $R'_1$ à $R'_{N-1}$ et un démultiplexeur 56. Les N-1 résistors $R'_1$ à $R'_{N-1}$ sont égaux à N-1 des N résistors $R_1$ à $R_N$. Les résistors $R'_1$ à $R'_{N-1}$ et l'oscillateur 12 sont reliés, de préférence connectés, au démultiplexeur 56. Le démultiplexeur 56 est commandé par un signal SEL' constant de façon à relier en permanence le noeud $N_1$ à l'entrée inverseuse (-) de l'amplificateur opérationnel 24, de telle façon que les resistors $R'_1$ à $R'_N$ ne soit jamais connectés à l'entrée inverseuse de l'amplificateur 24. La présence du démultiplexeur 56 permet d'assurer que les courants de fuites liés aux démultiplexeurs 28, 56 au niveau des entrées inverseuse et non inverseuse de l'amplificateur opérationnel 24 soient les plus proches possibles.

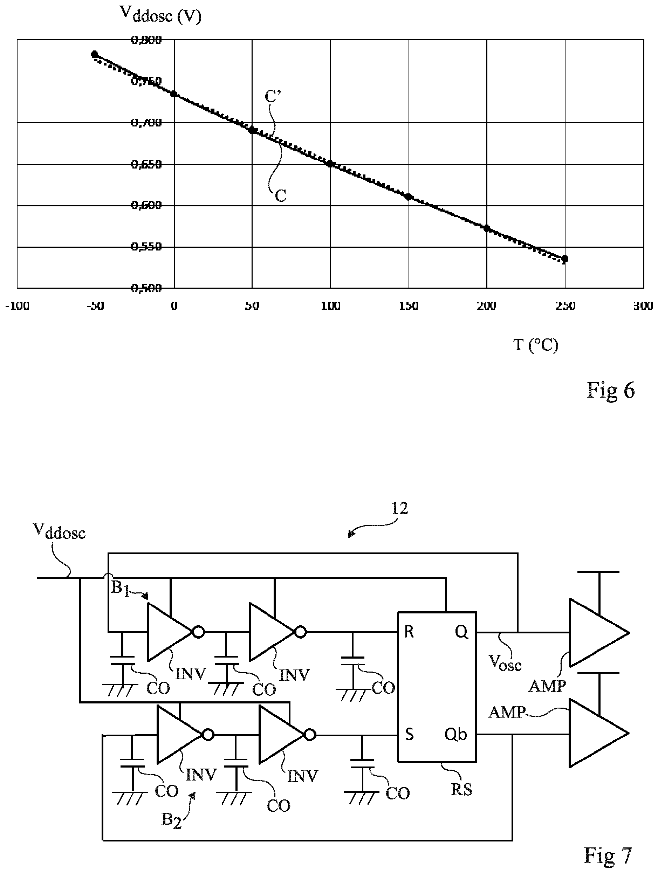

La figure 6 représente une courbe C, obtenue par simulation, d'évolution de la tension $V_{ddosc}$ du capteur de température 10 représenté en figure 5 en fonction de la température T. La courbe C' en pointillés représente la courbe qui serait obtenue si la tension $V_{ddosc}$ variait de façon parfaitement linéaire en fonction de la température T. Comme cela apparaît sur la figure 6, les courbes C et C' sont quasiment confondues de -50°C à 250°C de sorte que l'utilisation de la tension $V_{ddosc}$ comme signal représentatif de la température sur une grande plage de températures est pertinente.

La figure 7 représente un autre mode de réalisation de l'oscillateur 12 dans lequel l'oscillateur 12 comprend deux branches $B_1$ et $B_2$, chaque branche $B_1$, $B_2$ comprenant deux inverseurs INV en série alimentés par la tension $V_{ddosc}$. L'oscillateur 12 comprend, en outre, un verrou RS dont l'entrée R est reliée, de préférence connectée, à la sortie de la première branche $B_1$, dont l'entrée S est reliée, de préférence connectée, à la sortie du deuxième inverseur INV de la deuxième branche $B_2$, dont la sortie Q est reliée, de préférence connectée, à l'entrée du premier inverseur INV de la branche $B_1$ et dont la sortie Qb est reliée, de préférence connectée, à l'entrée du premier inverseur INV de la branche $B_2$. Le signal $V_{osc}$ fourni à la sorties Q et le signal complémentaire fourni à la sortie Qb peuvent être transmis à des amplificateurs AMP. L'oscillateur 12 peut comprendre des condensateurs CO en entrée et/ou en sortie des inverseurs INV.

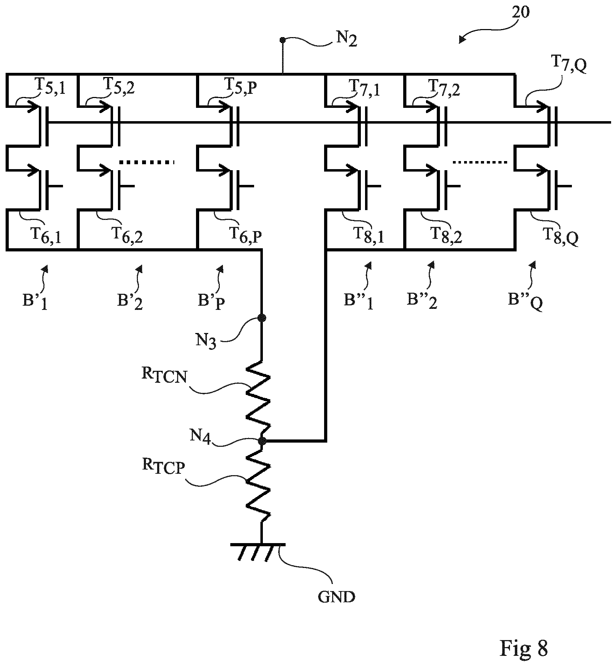

La figure 8 représente un autre mode de réalisation du circuit 20 de fourniture du signal de référence REF au noeud $N_2$ dans lequel le circuit 20 comprend un résistor $R_{TCN}$ ayant une résistance à coefficient en température négatif montée entre un noeud $N_3$ et un noeud $N_4$ et un résistor $R_{TCP}$ ayant une résistance à coefficient en température positif montée entre le noeud $N_4$ et la source GND du potentiel de référence bas. Le circuit 20 comprend, en outre, P branches $B'_i$, i varient de 1 à P, montées en parallèles entre le noeud $N_2$ et le noeud $N_4$ et Q branches $B''_k$, k variant de 1 à Q, montées en parallèles entre le noeud $N_2$ et le noeud $N_4$. Les branches $B'_1$ à $B'_P$ et $B''_1$ à $B''_Q$ permettent de commander le rapport entre le courant circulant dans le résistor $R_{TCN}$ et le courant circulant dans le résistor $R_{TCP}$. Chaque branche $B'_i$ peut comprendre une source de courant réalisée par exemple par un transistor MOS $T_{5,i}$, par exemple à canal P, toujours passant dont la valeur de la tension sur la grille fixe la valeur du courant le traversant, en série avec un transistor MOS $T_{6,i}$, par exemple à canal P. Chaque branche $B''_k$ peut comprendre un transistor MOS $T_{7,k}$, par exemple à canal P, toujours passant, dont la valeur de la tension sur la grille fixe la valeur du courant le traversant, en série avec un transistor MOS $T_{8,k}$, par exemple à canal P. Les grilles des transistors $T_{6,1}$ à $T_{6,P}$ et $T_{8,1}$ à $T_{8,Q}$ sont commandées à partir du signal SEL. Lorsque le transistor $T_{6,i}$ est mis à l'état passant, il est adapté à laisser passer un courant égal à $a_i I$. Lorsque le transistor $T_{8,k}$ est mis à l'état passant, est adapté à laisser passer un courant égal à $b_k I$. De ce fait, la résistance $R_{EQ}$ équivalente du circuit 20 est donnée par la relation 4) suivante :

$$[\text{Math 4}] \qquad R_{EQ} = R_{TCN} \sum a_i + R_{TCP} \left( \sum a_i + \sum b_k \right)$$

La valeur de la résistance $R_{EQ}$ reliée au noeud $N_2$ peut donc être commandée en modifiant le nombre de transistors $T_{6,i}$ qui sont à l'état passant parmi les P transistors $T_{6,i}$ à $T_{6,p}$ et/ou le nombre de transistors $T_{8,k}$ qui sont à l'état passant parmi les Q transistors $T_{8,1}$ à $T_{8,Q}$. Le circuit 20 de la figure 8 présente de façon avantageuse des courants de fuite réduits.

Divers modes de réalisation et variantes ont été décrits. L'homme de l'art comprendra que certaines caractéristiques de ces divers modes de réalisation et variantes pourraient être combinées, et d'autres variantes apparaîtront à l'homme de l'art. En particulier, d'autres architectures du circuit de commande 16 de la source de courant commandable, asservissant la résistance équivalente de l'oscillateur 12 à une résistance de référence, que celle représentée en figure 2 peuvent être mises en oeuvre. En outre, dans les modes de réalisation décrits précédemment, le circuit 20 de fourniture du signal de référence REF comprend plusieurs résistors. Selon un autre mode de réalisation, le circuit 20 de fourniture du signal de référence REF comprend un résistor unique dont la résistance est sensiblement constante sur la plage de températures et le démultiplexeur 28 et le circuit de sélection 34 peuvent ne pas être présents. Enfin, la mise en oeuvre pratique des modes de réalisation et variantes décrits est à la portée de l'homme du métier à partir des indications fonctionnelles données ci-dessus.

**Revendications**

1. Capteur de température fournissant un signal de mesure ($V_{ddosc}$) de la température, comprenant une source de courant commandable, un oscillateur (12) et un circuit de commande (16) de la source de courant commandable, **caractérisé en ce que** le circuit de commande est configuré pour asservir la résistance équivalente de l'oscillateur à une résistance de référence, l'oscillateur étant alimenté par la source de courant commandable en un premier noeud ($N_1$) présentant une tension d'alimentation ($V_{ddosc}$), l'oscillateur fournissant un premier signal oscillant ($V_{osc}$) ayant une dynamique égale à la tension d'alimentation ($V_{ddosc}$), le signal de mesure correspondant à la tension d'alimentation.

2. Capteur de température selon la revendication 1, dans lequel la source de courant commandable comprend un premier transistor MOS ($T_1$) dont la source est destinée à être reliée à une source ($V_{dd}$) d'un potentiel de référence haut, dont le drain fournit la tension d'alimentation ($V_{ddosc}$) au premier noeud ($N_1$) et dont la grille est commandée par le circuit de commande (16).

3. Capteur de température selon la revendication 1 ou 2, comprenant un convertisseur analogique-numérique (32) recevant la tension d'alimentation ($V_{ddosc}$) et fournissant un signal numérique converti (ST) au circuit de commande (16), le circuit de commande étant configuré pour sélectionner une résistance parmi plusieurs résistances à partir du signal numérique converti, lesdites résistances étant sensiblement égales à la résistance de référence dans des sous-plages différentes de températures d'une plage de températures.

4. Capteur de température selon la revendication 3, comprenant un circuit suiveur (30) recevant la tension d'alimentation ($V_{ddosc}$) et fournissant en sortie une recopie de la tension d'alimentation et dans lequel le convertisseur analogique-numérique (32) est relié à la sortie du circuit suiveur (30).

5. Capteur de température selon l'une des revendications 2 à 4, dans lequel le circuit de commande (16) et la source de courant commandable comprennent un miroir de courant (26) comprenant le premier transistor MOS ($T_1$) et un deuxième transistor MOS ($T_2$), le circuit de commande comprenant, en outre, un amplificateur opérationnel (24) dont la sortie est reliée aux grilles des premier et deuxième transistors MOS, et dans lequel le premier noeud ($N_1$) est relié à une première entrée (-) de l'amplificateur opérationnel (24) et dans lequel le circuit de commande (16) comprend un circuit de fourniture (20) d'une tension de référence (REF) à une deuxième entrée (+) de l'amplificateur opérationnel (24), le deuxième transistor MOS ($T_2$) étant traversé par un courant, le circuit de fourniture (20) étant configuré pour fournir la tension de référence (REF) égale au produit dudit courant et de la résistance de référence.

6. Capteur de température selon la revendication 5 dans son rattachement à la revendication 3, dans lequel le circuit de fourniture (20) de la tension de référence (REF) est adapté à relier la deuxième entrée (+) à l'une desdites résistances à partir d'un signal de sélection (SEL).

7. Capteur de température selon la revendication 6 dans son rattachement à la revendication 3, dans lequel le circuit de commande (16) comprend un circuit numérique (34) recevant le signal numérique converti (ST) et déterminant le signal de sélection (SEL) à partir du signal numérique converti de façon à sélectionner la résistance, parmi les résistances, celle sensiblement égale à la résistance de référence.

8. Capteur de température selon la revendication 6 ou 7, dans lequel le circuit de fourniture (20) de la tension de référence (REF) comprend des premiers résistors ($R_1$, $R_N$), les premiers résistors ayant des résistances sensiblement égales à la résistance de référence dans des sous-plages différentes de températures d'une plage de températures, et un démultiplexeur (28) adapté à relier l'un des premiers résistors à la deuxième entrée (-) à partir du signal de sélection (SEL).

9. Capteur de température selon la revendication 6 ou 7, dans lequel le circuit de fourniture (20) de la tension de référence (REF) comprend un deuxième résistor ($R_{TCP}$) à résistance à coefficient de température positif relié à un troisième résistor ($R_{TCN}$) à résistance à coefficient de température négatif et un circuit adapté à modifier le rapport entre le courant circulant dans le deuxième résistor et le courant circulant dans le troisième résistor.

10. Capteur de température selon l'une quelconque des revendications 2 à 9, dans lequel l'oscillateur (12) comprend des troisièmes transistors MOS ($TUP_1$, $TDOWN_1$).

11. Capteur de température selon l'une quelconque des revendications 1 à 10, dans lequel le premier signal oscillant (Vosc) oscille à une première fréquence d'oscillation, le capteur de température comprenant un circuit diviseur de fréquence (40) recevant le premier signal oscillant ($V_{osc}$) ou un deuxième signal ($V'_{osc}$) oscillant à la première fréquence d'oscillation et fournissant un troisième signal (Clk) oscillant à une deuxième fréquence d'oscillation qui est un sous-multiple de la première fréquence d'oscillation.

12. Capteur de température selon la revendication 11 dans son rattachement à la revendication 3, dans lequel le convertisseur analogique-numérique (32) est cadencé par le troisième signal oscillant (Clk).

13. Capteur de température selon l'une quelconque des revendications 1 à 12, dans lequel l'oscillateur (12) est un oscillateur en anneau.

14. Capteur de température selon la revendication 13, dans lequel la tension à chaque noeud interne de l'oscillateur (12) a une dynamique égale à la tension d'alimentation ($V_{ddosc}$) de l'oscillateur.

15. Capteur de température selon la revendication 10, dans lequel les troisièmes transistors MOS ($TUP_1$, $TDOWN_1$) sont configurés pour être traversés par un courant variant de façon linéaire, à 10 % prés, en fonction de la température sur une plage de températures, le capteur étant configuré pour fournir le signal de mesure ($V_{ddosc}$) variant de façon linéaire, à 10 % près, en fonction de la température au moins sur la plage de températures.

16. Capteur de température selon la revendication 14, dans lequel la plage de températures varie de -40°C à 250°C.

**Patentansprüche**

1. Temperatursensor, der ein Messsignal ($V_{ddosc}$) der Temperatur liefert, aufweisend eine steuerbare Stromquelle, einen Oszillator (12) und eine Schaltung (16), die die steuerbare Stromquelle steuert, **dadurch gekennzeichnet,**

**dass** die Steuerschaltung konfiguriert ist zum Steuern des Ersatzwiderstands des Oszillators so, dass er gleich einem Referenzwiderstand ist, wobei der Oszillator von der steuerbaren Stromquelle an einem ersten Knoten (N1) mit einer Versorgungsspannung ($V_{ddosc}$) versorgt wird, wobei der Oszillator ein erstes Schwingungssignal ($V_{osc}$) mit einer Dynamik gleich der Versorgungsspannung ($V_{ddosc}$) liefert, wobei das Messsignal der Versorgungsspannung entspricht.

2. Temperatursensor nach Anspruch 1, wobei die steuerbare Stromquelle einen ersten MOS-Transistor ($T_1$) aufweist, dessen Source zur Kopplung mit einer Quelle ($V_{dd}$) eines hohen Bezugspotentials konfiguriert ist, dessen Drain die Versorgungsspannung ($V_{ddosc}$) an den ersten Knoten ($N_1$) liefert und dessen Gate von der Steuerschaltung (16) gesteuert wird.

3. Temperatursensor nach Anspruch 1 oder 2, aufweisend einen Analog-Digital-Wandler (32), der die Versorgungsspannung ($V_{ddosc}$) empfängt und der Steuerschaltung (16) ein umgewandeltes Digitalsignal (ST) liefert, wobei die Steuerschaltung konfiguriert ist zum Auswählen eines Widerstands aus mehreren Widerständen aus dem umgewandelten Digitalsignal, wobei die Widerstände in unterschiedlichen Temperaturteilbereichen eines Temperaturbereichs im Wesentlichen gleich dem Referenzwiderstand sind.

4. Temperatursensor nach Anspruch 3, aufweisend eine Folgeschaltung (30), die die Versorgungsspannung ($V_{ddosc}$) empfängt und eine Kopie der Versorgungsspannung ($V_{ddosc}$) ausgibt, und wobei der Analog-Digital-Wandler (32) mit dem Ausgang der Folgeschaltung (30) gekoppelt ist.

5. Temperatursensor nach einem der Ansprüche 2 bis 4, wobei die Steuerschaltung (16) und die steuerbare Stromquelle einen Stromspiegel (26) aufweisen, der den ersten MOS-Transistor ($T_1$) und einen zweiten MOS-Transistor ($T_2$) aufweist, wobei die Steuerschaltung ferner einen Operationsverstärker (24) aufweist, dessen Ausgang mit den Gates der ersten und zweiten MOS-Transistoren gekoppelt ist, und wobei der erste Knoten ($N_1$) mit einem ersten Eingang (-) des Operationsverstärkers (24) gekoppelt ist und wobei die Steuerschaltung (16) eine Schaltung (20) aufweist, die eine Referenzspannung (REF) an einen zweiten Eingang (+) des Operationsverstärkers (24) liefert, wobei ein Strom durch den zweiten MOS-Transistor ($T_2$) fließt, wobei die Versorgungsschaltung (20) konfiguriert ist zum Liefern der Referenzspannung (REF) gleich dem Produkt aus dem Strom und dem Referenzwiderstand.

6. Temperatursensor nach Anspruch 5 in Verbindung mit Anspruch 3, wobei die Schaltung (20), die die Referenzspannung (REF) liefert, konfiguriert ist zum Koppeln des zweiten Eingangs (+) mit einem der Widerstände von einem Auswahlsignal (SEL).

7. Temperatursensor nach Anspruch 6 in Verbindung mit Anspruch 3, wobei die Steuerschaltung (16) eine digitale Schaltung (34) aufweist, die das umgewandelte digitale Signal (ST) empfängt und das Auswahlsignal (SEL) aus dem umgewandelten digitalen Signal bestimmt, um den Widerstand aus den Widerständen auszuwählen, der im Wesentlichen gleich dem Referenzwiderstand ist.

8. Temperatursensor nach Anspruch 6 oder 7, wobei die Schaltung (20), die die Referenzspannung (REF) liefert, erste Widerstände ($R_1$, $R_N$) aufweist, wobei die ersten Widerstände Widerstände aufweisen, die in verschiedenen Temperaturteilbereichen eines Temperaturbereichs im Wesentlichen gleich dem Referenzwiderstand sind, und einen Demultiplexer (28), der konfiguriert ist zum Koppeln von einem der ersten Widerstände mit dem zweiten Eingang (-) des Auswahlsignals (SEL).

9. Temperatursensor nach Anspruch 6 oder 7, wobei die Schaltung (20), die die Referenzspannung (REF) liefert, einen zweiten Widerstand ($R_{TCP}$) mit einem Widerstand mit positivem Temperaturkoeffizienten aufweist, der mit einem dritten Widerstand ($R_{TCN}$) mit einem Widerstand mit negativem Temperaturkoeffizienten gekoppelt ist, sowie eine Schaltung, die konfiguriert ist zum Modifizieren des Verhältnis zwischen dem Strom, der in dem zweiten Widerstand fließt, und dem Strom, der in dem dritten Widerstand fließt.

10. Temperatursensor nach einem der Ansprüche 2 bis 9, wobei der Oszillator (12) dritte MOS-Transistoren ($TUP_1$, $TDOWN_1$) aufweist.

11. Temperatursensor nach einem der Ansprüche 1 bis 10, wobei das erste Oszillationssignal (Vosc) mit einer ersten Oszillationsfrequenz oszilliert, wobei der Temperatursensor eine Frequenzteilerschaltung (40) aufweist, die das erste Oszillationssignal ($V_{osc}$) oder ein zweites Signal ($V'_{osc}$), das mit der ersten Oszillationsfrequenz oszilliert, empfängt und ein drittes Signal (Clk) liefert, das mit einer zweiten Oszillationsfrequenz oszilliert, die ein Untervielfaches der ersten Oszillationsfrequenz ist.

12. Temperatursensor nach Anspruch 11 in Verbindung mit Anspruch 3, wobei der Analog-Digital-Wandler (32) durch das dritte oszillierende Signal (Clk) getaktet wird.

13. Temperatursensor nach einem der Ansprüche 1 bis 12, wobei der Oszillator (12) ein Ringoszillator ist.

14. Temperatursensor nach Anspruch 13, wobei die Spannung an jedem internen Knoten des Oszillators (12) eine Dynamik aufweist, die gleich der Versorgungsspannung ($V_{ddosc}$) des Oszillators ist.

15. Temperatursensor nach Anspruch 10, wobei die dritten MOS-Transistoren ($TUP_1$, $TDOWN_1$) konfiguriert sind zum linearen Variieren eines durch sie hindurchfließenden Stroms, innerhalb von 10%, als Funktion der Temperatur über einen Temperaturbereich hinweg, wobei der Sensor konfiguriert ist zum Liefern des Messsignals ($V_{ddosc}$), das linear innerhalb von 10% als Funktion der Temperatur zumindest über den Temperaturbereich variiert.

16. Temperatursensor nach Anspruch 14, wobei sich der Temperaturbereich von -40°C bis 250°C erstreckt.

## Claims

1. A temperature sensor supplying a measurement signal ($V_{ddosc}$) of the temperature, comprising a controllable current source, an oscillator (12) and a circuit (16) controlling the controllable current source, **characterized in that** the control circuit is configured to control the equivalent resistance of the oscillator to be equal to a reference resistance, the oscillator being supplied by the controllable current source at a first node ($N_1$) having a supply voltage ($V_{ddosc}$) , the oscillator supplying a first oscillating signal ($V_{osc}$) having a dynamic equal to the supply voltage ($V_{ddosc}$) , the measuring signal corresponding to the supply voltage.

2. The temperature sensor according to claim 1, wherein the controllable current source comprises a first MOS transistor ($T_1$) whose source is configured to be coupled to a source ($V_{dd}$) of a high reference potential, whose drain supplies the supply voltage ($V_{ddosc}$) to the first node ($N_1$), and whose gate is controlled by the control circuit (16).

3. The temperature sensor according to claim 1 or 2, comprising an analog-digital converter (32) receiving the supply voltage ($V_{ddosc}$) and supplying a converted digital signal (ST) to the control circuit (16), the control circuit being configured to select a resistance among several resistances from the converted digital signal, said resistances being substantially equal to the reference resistance in different temperature subranges of a temperature range.

4. The temperature sensor according to claim 3, comprising a follower circuit (30) receiving the supply voltage ($V_{ddosc}$) and outputting a copy of the supply voltage ($V_{ddosc}$) and wherein the analog-digital converter (32) is coupled to the output of the follower circuit (30).

5. The temperature sensor according to any one of claims 2 to 4, wherein the control circuit (16) and the controllable current source comprise a current mirror (26) comprising the first MOS transistor ($T_1$) and a second MOS transistor ($T_2$), the control circuit further comprising an operational amplifier (24) whose output is coupled to the gates of the first and second MOS transistors, and wherein the first node ($N_1$) is coupled to a first input (-) of the operational amplifier (24) and wherein the control circuit (16) comprises a circuit (20) supplying a reference voltage (REF) to a second input (+) of the operational amplifier (24), a current passing through the second MOS transistor ($T_2$), the supply circuit (20) being configured to supply the reference voltage (REF) equal to the product of said current and the reference resistance.

6. The temperature sensor according to claim 5 attached to claim 3, wherein the circuit (20) supplying the reference voltage (REF) is configured to couple the second input (+) to one of said resistances from a selection signal (SEL).

7. The temperature sensor according to claim 6 attached to claim 3, wherein the control circuit (16) comprises a digital circuit (34) receiving the converted digital signal (ST) and determining the selection signal (SEL) from the converted digital signal in order to select the resistance, among the resistances, substantially equal to the reference resistance.

8. The temperature sensor according to claim 6 or 7, wherein the circuit (20) supplying the reference voltage (REF) comprises first resistors ($R_1$, $R_N$), the first resistors having resistances substantially equal to the reference resistance in different temperature subranges of a temperature range, and a demultiplexer (28) configured to couple one of the first resistors to the second input (-) from the selection signal (SEL).

9. The temperature sensor according to claim 6 or 7, wherein the circuit (20) supplying the reference voltage (REF) comprises a second resistor ($R_{TCP}$) having a resistance with a positive temperature coefficient coupled to a third resistor ($R_{TCN}$) having a resistance with a negative temperature coefficient and a circuit configured to modify the ratio between the current circulating in the second resistor and the current circulating in the third resistor.

10. The temperature sensor according to any one of claims 2 to 9, wherein the oscillator (12) comprises third MOS transistors ($TUP_1$, $TDOWN_1$).

11. The temperature sensor according to any one of claims 1 to 10, wherein the first oscillating signal (Vosc) oscillates at a first oscillation frequency, the temperature sensor comprising a frequency divider circuit (40) receiving the first oscillating signal ($V_{osc}$) or a second signal ($V'_{osc}$) oscillating at the first oscillation frequency and supplying a third signal (Clk) oscillating at a second oscillation frequency that is a sub-multiple of the first oscillation frequency.

12. The temperature sensor according to claim 11 attached to claim 3, wherein the analog-digital converter (32) is paced by the third oscillating signal (Clk).

13. The temperature sensor according to any one of claims 1 to 12, wherein the oscillator (12) is a ring oscillator.

14. The temperature sensor according to claim 13, wherein the voltage at each internal node of the oscillator (12) has a dynamic equal to the supply voltage ($V_{ddosc}$) of the oscillator.

15. The temperature sensor according to claim 10, wherein the third MOS transistors ($TUP_1$, $TDOWN_1$) are configured to have a current passing through them varying linearly to within 10% as a function of the temperature over a temperature range, the sensor being configured to supply the measuring signal ($V_{ddosc}$) varying linearly to within 10% as a function of the temperature at least over the temperature range.

16. The temperature sensor according to claim 14, wherein the temperature range varies from -40°C to 250°C.

Fig 1

Fig 2

Fig 3

Fig 4

Fig 5

EP 3 667 275 B1

Vddosc (V)

Fig 6

Fig 7

Fig 8

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2017038264 A
- US 2009096495 A
- WO 2018115864 A